# EUROPEAN PATENT SPECIFICATION

(11) **EP 3 093 992 B1**
(45) Date of publication and mention of the grant of the patent: **10.03.2021**
(21) Application number: 15167723.4
(22) Date of filing: 14.05.2015
(51) Int. Cl.: H03K 3/356

(54) **AN INPUT CLOCKED COMPARATOR CIRCUIT OF AN EQUIVALENT TIME SAMPLING CONVERTER**
GETAKTETE EINGABEKOMPARATORSCHALTUNG EINES ABTASTWANDLERS MIT ÄHNLICHEM TAKT
CIRCUIT COMPARATEUR CADENCÉ D'ENTRÉE D'UN CONVERTISSEUR D'ÉCHANTILLONNAGE ÉQUIVALENT DANS LE TEMPS

(43) Date of publication of application: 16.11.2016
(73) Proprietor: Institute of Electronics and Computer Science, 1006 Riga (LV)
(72) Inventor: Aristovs, Vladimirs, 1006 Riga (LV); Supols, Gatis, 1006 Riga (LV); Savelis, Rolands, 1006 Riga (LV); Cirulis, Rudolfs, 1006 Riga (LV)

(56) References cited:
- AGAFONOVS N ET AL: "Design and evaluation of a stroboscopic signal converter based on discrete transistor clocked comparator", ELECTRONICS CONFERENCE (BEC), 2012 13TH BIENNIAL BALTIC, IEEE, 3 October 2012 (2012-10-03), pages 69-72, XP032277591, DOI: 10.1109/BEC.2012.6376817 ISBN: 978-1-4673-2775-6
- GREITANS M ET AL: "Analytic model and bilateral approximation for clocked comparator", SIGNALS AND ELECTRONIC SYSTEMS (ICSES), 2010 INTERNATIONAL CONFERENCE ON, IEEE, PISCATAWAY, NJ, USA, 7 September 2010 (2010-09-07), pages 185-188, XP031770755, ISBN: 978-1-4244-5307-8
- GARUTS V E ED - JOPKE J: "Design and evaluation of a 5 GHz HBT strobed comparator", BIPOLAR/BICMOS CIRCUITS AND TECHNOLOGY MEETING, 1992., PROCEEDINGS OF THE 1992 MINNEAPOLIS, MN, USA 7-8 OCT. 1992, NEW YORK, NY, USA,IEEE, US, 7 October 1992 (1992-10-07), pages 143-146, XP010104570, DOI: 10.1109/BIPOL.1992.274064 ISBN: 978-0-7803-0727-8

## Description

### Technical field

This invention relates to electrical circuits and more particularly to the input clocked comparator circuit of an equivalent-time sampling converter for high-speed repetitive signals.

### Background art

A design of the input clocked comparator of an equivalent-time sampling converter is described in two publications: *"*M.Greitans, E.Hermanis and G.Supols. Analytic Model and Bilateral Approximation for Clocked Comparator. ICSES 2010-The international Conference on Signal and Electronic Systems, Gliwice, Poland, September 7-10, 2010*"* and *"*N. Agafonov and G. Supols. Design and evaluation of a stroboscopic signal converter based on discrete transistor clocked comparator. 13th Biennial Baltic Electronics Conference (BEC2012), Tallinn, Estonia, October 3-5, 2012*".*

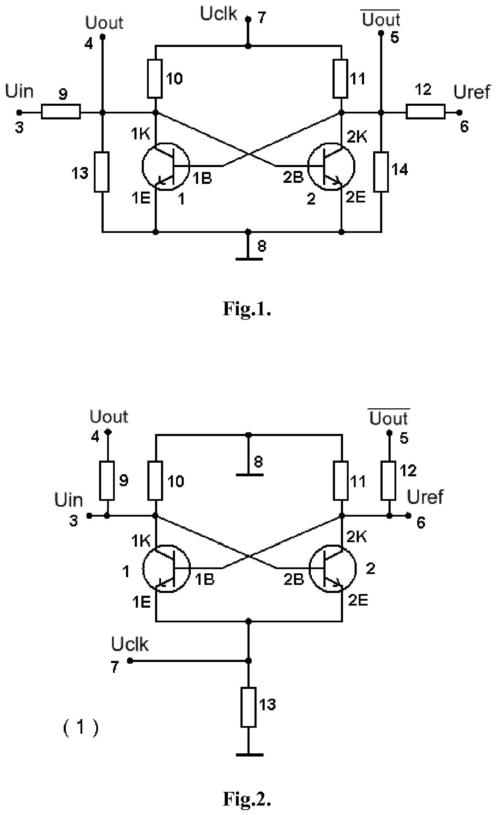

The first and the second transistors of the said clocked comparator in Fig.1 have their emitter terminals connected to a common bus, while their collector terminals are connected to a strobe pulse input through collector resistors. The base terminal of the first transistor is connected to the collector terminal of the second transistor, while the base terminal of the second transistor is connected to the collector terminal of the first transistor. A high-speed input signal is applied through a decoupling resistor to the collector terminal of the first transistor, while a reference voltage through another decoupling resistor is applied to the collector terminal of the second transistor. The collector terminals of both transistors are connected through matching resistors to a common bus.

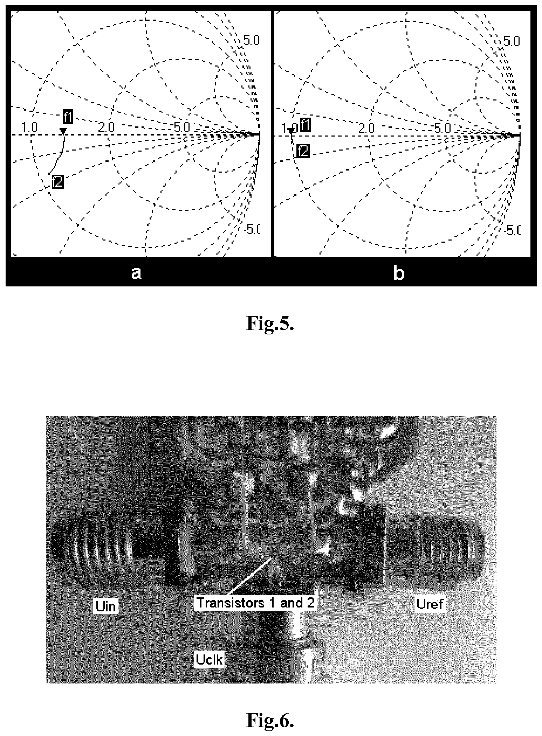

The clocked comparator in Fig.1 cannot be optimally matched to the high-speed input voltage source impedance because it is not possible to find such values of collector, decoupling and matching resistors that allow both to set the switching mode of RF transistors (hereinafter as an example the transistors BFP420 with a transition frequency of 25 GHz will be used for calculations) and to match the input impedance *Rᵢₙ* of the comparator to the characteristic impedance *R*₀ of the line. The input circuit, at first approximation, can be assumed to be equal to a parallel circuit composed of two branches with one branch consisting of one resistor and the other branch consisting of one resistor and one capacitor connected in series. At low frequencies the capacitor is nearly an open circuit and the equivalent resistance turns out to be greater than *R*₀. The behaviour of the input impedance in the frequency range from 0.1 GHz to 3 GHz is presented on the Smith Chart in Fig.5a. As it follows from the chart, the input impedance at lower frequency range equals *Zᵢₙ* = 66 - *j*1.05, and at higher frequency range *Zᵢₙ* = 53 - *j*21.7. The corresponding absolute values of the reflection coefficient Γ(*ƒ*) are equal to 0.138 and 0.208.

Previously known circuits of the input clocked comparators of the equivalent-time sampling converters are described in US Patent No.5523760, in *"*V.E.Garuts. Design and Evaluation of a 5 GHz HBT Strobed Comparator. Proc. IEEE BCTM 1992, pp. 143-146, Oct. 1992*",* and in *"*A.G.Perrey, H.K.Schoenwetter. A Schottky diode bridge sampling gate. NBS Technical note 1121, 1980*".* These circuits, for measuring the input signal, comprise sampling gates built on diode switches, Schottky diode bridges and FET transistors or sampling delta modulators built on high speed comparators. A disadvantage of such devices is either the need to form short gating pulses of duration tens to hundreds of picoseconds or the complexity of the comparator circuits comprising several tens of active elements.

The present invention aims at increasing the efficiency of the input clocked comparator of the equivalent-time sampling converter by matching the input impedance of the device to the characteristic impedance of the transmission line through which the high-speed input signal is provided to the circuit. This allows decreasing the reflections of the signal from the input of the device over a wide frequency band.

### Summary of the invention

The aim of the present invention is achieved by designing an input clocked comparator circuit as shown in Fig.2, the main elements of which are connected in the following manner. The collector terminal of the first transistor is connected: to the input terminal of the high-speed input signal; to the output terminal of the output signal through a decoupling resistor; to a common bus through a collector resistor; and to the base terminal of the second transistor. Similarly, the collector terminal of the second transistor is connected: to the input terminal of the reference voltage; to the output terminal of the inverse output signal through another decoupling resistor; to a common bus through another collector resistor; and to the base terminal of the first transistor. The emitter terminals of both transistors are connected: to the input terminal of the strobe pulse signal; and to a common bus through an emitter resistor. Such a design of the clocked comparator provides an exact match between the input impedance of the device and the characteristic impedance of the transmission line through which the high-speed input signal is applied to the circuit.

### Brief description of drawings

Fig.1 shows a prior art circuit of the clocked comparator of the equivalent-time sampling converter.
Fig.2 shows the clocked comparator circuit (1) of the present invention.
Fig.3 shows a block-diagram of the equivalent-time sampling converter comprising the clocked comparator (block **Comp**) of the present invention.
Fig.4 illustrates the timing diagrams explaining the principle of operation of the clocked comparator of the equivalent-time sampling converter.
Fig.5 shows the Smith charts comparing the behaviour of the input impedances of the clocked comparators of prior art (Fig.5a) and of present invention (Fig.5b) in the frequency range from 0.1 GHz to 3 GHz.
Fig. 6 shows an exterior layout of the present invention.

### Detailed description of the invention

Next, by referring to drawings, the present invention will be described in detail.

The clocked comparator circuit of the present invention is shown in Fig.2. The components of the circuit are connected in the following manner. The collector terminal **1K** of the first transistor **1** is connected: to the input terminal **3** of the high-speed input signal **Uin;** to the output terminal **4** of the output signal **Uout** through a decoupling resistor **9;** to a common bus **8** through a collector resistor **10;** and to the base terminal **2B** of the second transistor **2.** Similarly, the collector terminal **2K** of the second transistor **2** is connected: to the input terminal **6** of the reference voltage **Uref;** to the output terminal **5** of the inverse output signal **U̅o̅u̅t** through a decoupling resistor **12;** to a common bus **8** through a collector resistor **11;** and to the base terminal **1B** of the first transistor **1.** The emitter terminals **1E** and **2E** of both transistors are connected: to the input terminal **7** of the strobe pulse signal **Uclk;** and to a common bus **8** through an emitter resistor **13.**

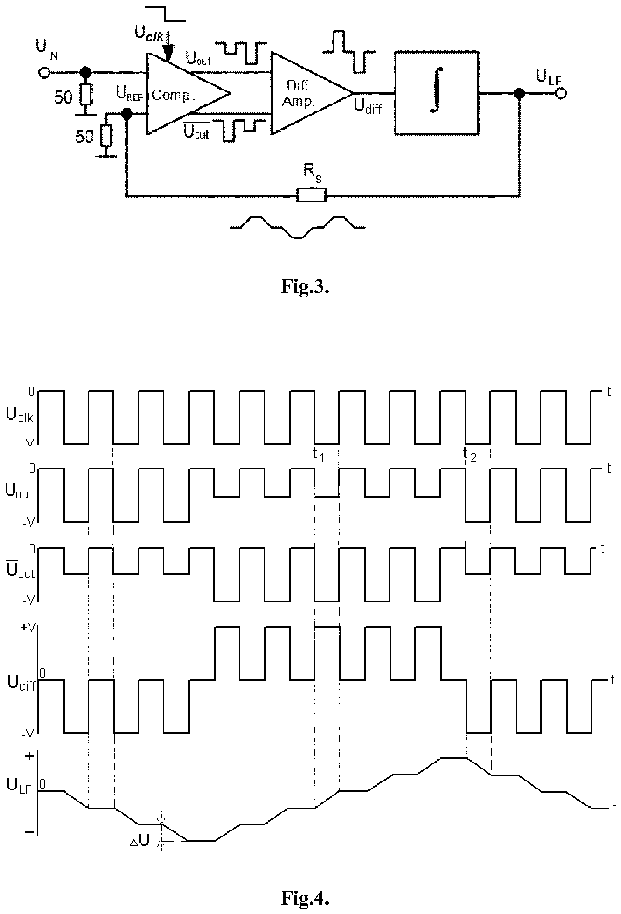

Fig.3 shows a block-diagram of the equivalent-time sampling converter comprising the clocked comparator (block **Comp)** of the present invention. The corresponding timing diagrams, which explain the principle of operation of the clocked comparator as the part of the equivalent-time sampling converter, are shown in Fig.4.

The input signals of the clocked comparator of the equivalent-time sampling converter are denoted by **Uin,** which is the high-speed input repetitive signal, and **Uref,** which is the reference voltage. Although these two voltages are permanently present at the input terminals **3** and **6,** their comparison is carried out only on falling edges of the strobe pulses **Uclk,** which are applied to the input terminal **7.** Suppose at some point in time **t1** the input voltages **Uin** and **Uref** are such that **Uin>Uref.** After falling edge of **Uclk,** a negative supply voltage (-V) is applied to the emitter terminals **1E** and **2E** of transistors **1** and **2.** As **Uin>Uref,** the base current of transistor **2** begins to exceed the base current of transistor **1,** and transistor **2** becomes more conductive, causing a drop in voltage at both the collector **2K** and the base **1B**. This in turn reduces the base current of transistor **1,** making it less conductive and so causing the voltage at both the collector **1K** and the base **2B** to rise, thus completing a positive feedback loop which allows fast changeover from non-conducting to conducting state of transistor **2.** After this changeover, the voltage **Uout** at the output terminal **4** exceeds the inverse voltage **U̅o̅u̅**t at the output terminal **5,** which are both connected to the inputs of a differential amplifier **"Diff Amp"** and produce a positive pulse at its output, which in turn is connected to the input of an integrator. As the pulse is positive, the output voltage **U_{LF}** of the integrator increases until the rising edge of **Uclk**, and so does the reference voltage **Uref** at the input terminal **6.** The integrator time constant is chosen as a compromise between accuracy of reproducing the input signal and a speed of conversion. If on the next falling edge of **Uclk** the relation **Uin>Uref** holds, then the process repeats and **Uref** increases again. This continues until at some point in time **t2** the reference voltage exceeds the high-speed input signal voltage, i.e., **Uin<Uref.** In this case the changeover from conducting to non-conducting state of transistor **2** takes place, and the voltage **Uout** becomes less than the inverse voltage **U̅o̅u̅t**. This produces a negative pulse at the output of the differential amplifier **"Diff Amp"** and thus at the input of the integrator. As the pulse is negative, the output voltage **U_{LF}** decreases until the rising edge of **Uclk,** and so does the reference voltage **Uref.** If on the next falling edge of **Uclk** the relation **Uin<Uref** holds, then the process repeats and **Uref** decreases further. In this way the output signal **U_{LF}** follows the high-speed input signal voltage **Uin** on the falling edges of **Uclk,** which are shifted in time by a constant amount using an automatic-shift circuit in order to cover the whole period of the high-speed input signal. A waveform of the obtained low-frequency output signal **U_{LF}** conforms to the waveform of the high-speed input signal **Uin** with the only difference that **U_{LF}** is stretched in time by a stretch factor known as the transformation coefficient.

Impedance matching between the clocked comparator and the sources **Uin** and **Uref,** as well as setting up the switching mode of transistors **1** and **2,** is accomplished by collector resistors **10** and **11.** Their values of 50 ohms allow both to satisfy the requirement *Rᵢₙ = R*₀ and to operate the transistors in switching mode. The values of decoupling resistors **9** and **12** are chosen to satisfy: *R*₉ >> *R*₁₀ and *R*₁₂ >> *R*₁₁*.* In this way influence of the decoupling resistors **9** and **12** on both the input impedance and the operation of the transistors is minimized. For impedance matching between a cable and the input **7,** a value of the emitter resistor **13** is chosen to be equal to *R*₀.

Fig.5 shows the Smith charts comparing the behaviour of the input impedances of the clocked comparators of prior art (Fig.5a) and of present invention (Fig.5b) in the frequency range from 0.1 GHz to 3 GHz. As it follows from Fig.5a, the input impedance of the clocked comparator of prior art equals 66 - *j*1.05 at lower frequency range and 53 - *j*21.7 at higher frequency range, and the corresponding absolute values of the reflection coefficient are 0.138 and 0.208. Whereas from Fig.5b it follows that the input impedances of the clocked comparator of the present invention are 50 - *j*0.1 and 50.7 - *j*4.55 at lower and higher frequency ranges respectively, while the corresponding absolute values of the reflection coefficient are 0.001 and 0.046. These numbers clearly show the advantage of the clocked comparator of the present invention, as 0.001 is only 0.72% of 0.138, and 0.046 is 22% of 0.208.

The equivalent-time sampling converter comprising the input clocked comparator of the present invention can be used in ground penetrating radar (GPR) systems in order to obtain the time stretched waveforms of the high-speed reflected electromagnetic pulses for location and delimitation of the layered subsurface environments and for identification of underground objects.

It should be understood by those skilled in the art that the structure and details of the present invention may be changed in various manners without departing from the scope of the present invention.

### List of reference numerals

(1) - an input clocked comparator of the equivalent-time sampling converter;
1 - a first transistor of the input clocked comparator;
1B - a base terminal of the first transistor;
1E - an emitter terminal of the first transistor;
1K - a collector terminal of the first transistor;
2 - a second transistor of the input clocked comparator;
2B - a base terminal of the second transistor;
2E - an emitter terminal of the second transistor;
2K - a collector terminal of the second transistor;
3 - an input terminal of the high-speed input signal;
4 - an output terminal of the output signal;
5 - an output terminal of the inverse output signal;
6 - an input terminal of the reference voltage;
7 - an input terminal of the strobe pulse signal;
8 - a common bus;
9 - a decoupling resistor of the input signal;
10 - a collector resistor of the first transistor;
11 - a collector resistor of the second transistor;
12 - a decoupling resistor of the reference voltage;
13 - an emitter resistor;
Uin - a high-speed input signal voltage;
Uref - a reference voltage;
Uout - an output signal voltage;
U̅o̅u̅t - an inverse output signal voltage;
Uclk - a strobe pulse signal voltage.

## Claims

1. An input clocked comparator (1) of an equivalent-time sampling converter comprising:
• a first transistor (**1**) with its:
∘ collector terminal (**1K**) connected to:
▪ the input terminal (**3**) of an high-speed input signal (**Uin**);
▪ the output terminal (**4**) of an output signal (**Uout**) through a first decoupling resistor (**9**);
▪ a common bus (**8**) through a first collector resistor (10) of the first transistor (**1**);
▪ the base terminal (**2B**) of a second transistor (**2**) of the clocked comparator;
∘ base terminal (**1B**) connected to:
▪ the collector terminal (**2K**) of the second transistor (**2**);
▪ the common bus (**8**) through a second collector resistor (**11**) of the second transistor (2);
▪ the output terminal (**5**) of the inverse output signal (**U̅o̅u̅t**) through a second decoupling resistor (**12**);
▪ input terminal (**6**) of a reference voltage (**Uref**);
∘ emitter terminal (**1E**) connected to the emitter terminal (**2E**) of the second transistor (**2**).
• a second transistor (**2**) with its:
∘ collector terminal (**2**K) connected to:
▪ the input terminal (**6**) of the reference voltage (**Uref**);
▪ the output terminal (**5**) of the inverse output signal **(U̅o̅u̅t)** through a the second decoupling resistor (**12**);
▪ the common bus (**8**) through the second collector resistor (11) of the second transistor (2);
▪ the base terminal **(1B)** of the first transistor (**1**) of the clocked comparator;
∘ base terminal (**2B**) connected to:
▪ the collector terminal **(1K)** of the first transistor (**1**);
▪ the common bus (**8**) through the first collector resistor (10) of the first transistor (1);
▪ the output terminal (**4**) of the output signal (**Uout**) through the first decoupling resistor (**9**);
▪ the input terminal (**3**) of the high-speed input signal (**Uin**);
∘ emitter terminal (**2E**) connected to the emitter terminal (**1E**) of the first transistor (**1**),
**characterized in that**
The input clocked comparator (1) of the equivalent-time sampling converter further comprises:
• an emitter resistor (**13**) with its one terminal connected to the emitters (**1E** and **2E**) of the first and second transistors and to an input (**7**) of a strobe pulse signal (**Uclk**), and the other terminal connected to a common bus.

## Patentansprüche

1. Ein eingangsgetakteter Komparator (1) eines Abtastwandlers mit äquivalenter Zeit, umfassend:
• den ersten Transistor (**1**) mit seinem:
∘ Kollektoranschluss (**1K**) verbunden mit:
▪ einem Eingangsanschluss (**3**) des Hochgeschwindigkeits-Eingangssignals (**Uin**);
▪ einem Ausgangsanschluss (**4**) eines Ausgangssignals (**Uout**) über den ersten Entkopplungswiderstand (**9**);
▪ einem gemeinsamen Bus (**8**) über den ersten Kollektorwiderstand (**10**) des ersten Transistors (**1**);
▪ dem Basisanschluss (**2B**) des zweiten Transistors (**2**) des getakteten Komparators;
∘ Basisanschluss **(1B)** verbunden mit:
▪ einem Kollektoranschluss (**2K**) des zweiten Transistors (**2**);
▪ einem gemeinsamen Bus (**8**) über den zweiten Kollektorwiderstand (**11**) des zweiten Transistors (**2**);
▪ einem Ausgangsanschluss (**5**) des inversen Ausgangssignals (**U̅o̅u̅t**) über den zweiten Entkopplungswiderstand (**12**);
▪ einem Eingangsanschluss (**6**) einer Referenzspannung (**Uref**);
∘ Emitteranschluss **(1E)** verbunden mit dem Emitteranschluss (**2E**) des zweiten Transistors (**2**).
• den zweiten Transistor (**2**) mit seinem:
∘ Kollektoranschluss (**2K**) verbunden mit:
▪ einem Eingangsanschluss (**6**) der Referenzspannung (Uref);
▪ einem Ausgangsanschluss (**5**) des inversen Ausgangssignals **(U̅o̅u̅t)** über den zweiten Entkopplungswiderstand (**12**);
▪ einem gemeinsamen Bus (**8**) über den zweiten Kollektorwiderstand (**11**) des zweiten Transistors (**2**);
▪ einem Basisanschluss **(1B)** des ersten Transistors (**1**) des getakteten Komparators;
∘ Basisanschluss (**2B**) verbunden mit:
▪ einem Kollektoranschluss (**1K**) des ersten Transistors (1**)**;
▪ einem gemeinsamen Bus (**8**) über den ersten Kollektorwiderstand (**10**) des ersten Transistors (**1**);
▪ einem Ausgangsanschluss (**4**) des Ausgangssignals (**Uout**) über den ersten Entkopplungswiderstand (**9**);
▪ einem Eingangsanschluss (**3**) des Hochgeschwindigkeits-Eingangssignals (**Uin**);
∘ Emitteranschluss (**2E**) verbunden mit dem Emitteranschluss **(1E)** des ersten Transistors (**1**),
**dadurch gekennzeichnet**
Der eingangsgetaktete Komparator (1) des Abtastwandlers mit äquivalenter Zeit umfasst ferner:
• einen Emitterwiderstand (**13**), dessen einer Anschluss mit den Emittern (**1E** und **2E**) des ersten und des zweiten Transistors sowie mit dem Eingang (7) des Strobimpulssignals (**Uclk**) verbunden ist, und der andere Anschluss ist mit einem gemeinsamen Bus verbunden.

## Revendications

1. Un comparateur séquencé d'entrée (1) d'un convertisseur d'échantillonnage à temps équivalent comprenant :
• un premier transistor (**1**) avec sa :
∘ borne de collecteur **(1K)** connectée à :
▪ la borne d'entrée (**3**) d'un signal d'entrée haute vitesse (**Uin**) ;
▪ la borne de sortie (**4**) d'un signal de sortie (**Uout**) à travers une première résistance de découplage (**9**) ;
▪ un bus commun (**8**) à travers une première résistance de collecteur (**1**0) du premier transistor (**1**) ;
▪ la borne de base (**2B**) d'un second transistor (**2**) du comparateur séquencé ;
∘ borne de base **(1B)** connectée à :
▪ la borne de collecteur (**2K**) du second transistor (**2**) ;
▪ le bus commun (**8**) à travers une seconde résistance de collecteur (**11**) du second transistor (**2**) ;
▪ la borne de sortie (**5**) du signal de sortie inverse (**U̅o̅u̅t**) à travers une seconde résistance de découplage (**12**) ;
▪ la borne d'entrée (**6**) d'une tension de référence (**Uref**) ;
∘ borne émettrice **(1E)** connectée à la borne émettrice (**2**E) du second transistor (**2**).
• un second transistor (**2**) avec sa :
∘ borne de collecteur (**2**K) connectée à :
▪ la borne d'entrée (**6**) de la tension de référence (**Uref**) ;
▪ la borne de sortie (**5**) du signal de sortie inverse **(U̅o̅u̅t)** à travers la seconde résistance de découplage (**12**) ;
▪ le bus commun (**8**) à travers la deuxième résistance de collecteur (**11**) du second transistor (**2**) ;
▪ la borne de base **(1B)** du premier transistor (**1**) du comparateur séquencé ;
∘ borne de base (**2B**) connectée à :
▪ la borne de collecteur (**1K**) du premier transistor (**1**) ;
▪ le bus commun (**8**) à travers la première résistance de collecteur (**10**) du premier transistor (**1**) ;
▪ la borne de sortie (**4**) du signal de sortie (**Uout**) à travers la première résistance de découplage (**9**) ;
▪ la borne d'entrée (**3**) du signal d'entrée haute vitesse ;
∘ borne émettrice (**2E**) connectée à la borne émettrice (**1E**) du premier transistor (**1**).
**Caractérisés en ce que :**
Le comparateur séquencé d'entrée (1) du convertisseur d'échantillonnage à temps équivalent comprend en outre :
• une résistance émettrice (**13**) avec son unique borne connectée aux émetteurs (**1E** et **2E**) des premier et second transistors et à une entrée (7) d'un signal d'impulsion stroboscopique (**Uclk**), et l'autre borne connectée à un bus commun.
